# EUROPEAN PATENT APPLICATION

(11) **EP 4 810 438 A1**
(43) Date of publication of application: **23.09.2026**
(21) Application number: 25857975.4
(22) Date of filing: 01.04.2025
(51) Int. Cl.: B81B 7/00, B81B 7/02, B81C 1/00, B81C 3/00, G01L 11/02

(54) **VACUUM MICRO-CAVITY INTERFEROMETER CHIP AND MANUFACTURING METHOD THEREFOR, AND WIDE-RANGE OPTICAL PRESSURE SENSOR**

(30) Priority: 13.01.2025 CN 202510045493
(71) Applicant: Shanghai Baiantek Sensing Technology Co., Ltd., Shanghai 201210 (CN); Shanghai Baiantek Semiconductor Co., Ltd., Shanghai 201816 (CN)
(72) Inventor: ZHONG, Shaolong, Shanghai 201201 (CN); LONG, Liang, Shanghai 201201 (CN); GUO, Zhihui, Shanghai 201201 (CN); ZHOU, Wei, Shanghai 201201 (CN); ZHANG, Xinxin, Shanghai 201201 (CN); GUO, Liangjie, Shanghai 201201 (CN)
(74) Representative: Elzaburu S.L.P.
(86) International application number: PCT/CN2025/086736
(87) International publication number: WO 2026/148738

(57) **Abstract**

The present disclosure relates to a vacuum microcavity interferometer chip, a manufacturing method, and a wide-range optical pressure sensor. The vacuum microcavity interferometer chip includes a first substrate and a second substrate, the second substrate and the first substrate are bonded together as a whole, a pressure sensitive film is manufactured on the first substrate, a first reflective surface is deposited on the pressure sensitive film, and a second reflective surface corresponding to the first reflective surface is deposited on the second substrate. After the two substrates are bonded, the first reflective surface and the second reflective surface form an F-P optical interference cavity, at least one getter cavity is formed in the first substrate and/or the second substrate, getter films are arranged on surfaces of the getter cavities, the getter cavities and the F-P optical interference cavity are separated and connected through gas passages, and the gas passage can be made sufficiently small, so as to prevent any small quantity of particles generated after getter activation from contaminating the optical films, leading to device failure; and the whole sensor is of a sealed structure and is not provided with a structure externally connected with the chip, so that the overall airtightness of the chip is ensured, and the vacuum degree requirement of subsequent housing packaging is reduced.

## Description

### TECHNICAL FIELD

The present disclosure relates to sensors in the field of optoelectronics. In particular, it concerns a wide-range vacuum microcavity interferometer chip based on the principle of a vacuum microcavity multi-beam interferometer, a manufacturing method, and a sensor utilizing the wide-range vacuum microcavity interferometer chip. The sensor is mainly intended for measuring pressure signals of fluid media such as gases and liquids, and can also be applied to the measurement and control of parameters including flow rate, flow velocity, density, liquid level, altitude, and contact acting force between objects.

### BACKGROUND ART

Pressure sensors refer to devices or equipment that can sense pressure signals of fluid media such as gases and liquids, and convert the pressure signals into usable output electric or optical signals according to a predetermined rule. The pressure sensors are one of the most commonly used sensors in industrial practice, which are widely applied in various industrial automatic control environments such as water conservancy and hydropower, railway transportation, Intelligent building, production automation, aerospace, military industry, petrochemicals, oil wells, power, ships, machine tools, pipelines, etc. and also been increasingly widely applied in the fields of consumer electronics such as medical equipment, robots and automotive electronics, smart phones, smart home appliances and wearable electronic products.

The product selling price of the pressure sensors mainly depends on applicable usage conditions and measurement precision that can be maintained for a long time. Industrial-grade pressure sensors with an operating temperature range of -55°C to 85°C and a precision of 0.01%, as well as sensors with temperature resistance exceeding 200°C and 0.1% precision across the entire temperature range, each cost several thousand to tens of thousands of yuan RMB. Pressure sensors with wide temperature ranges, high precision, and high reliability have strong demand in multiple fields such as nuclear power, aerospace, railway transportation, semiconductor equipment and process industries. The pressure sensors can be classified according to detection methods, such as electrical detection pressure sensors and optical detection pressure sensors. At present, among the electrical detection pressure sensors, resonant pressure sensors have been widely recognized by the market due to a series of advantages such as high temperature stability, high long-term stability, and high overall accuracy. However, the application of the resonant pressure sensors in high-temperature environments or occasions with radiation and electromagnetic interference is restricted. Optical fiber pressure sensors can meet the usage requirements in such occasions. An optical fiber sensing technology is a new technology that developed rapidly in the late 1970s, which is the application of fiber optics in non-communication fields. The optical fiber sensing technology can measure over a hundred types of physical quantities. It has the advantages of wide application range, high sensitivity, resistance to electromagnetic interference, good insulation, corrosion resistance, flexibility, compact size, low cost, and good compatibility with optical fiber transmission lines.

An optical fiber Fabry-Perot (F-P) pressure sensor is a type of optical fiber pressure sensor. Usually, a Fabry-Perot micro-resonant cavity is formed by an optical fiber end face and a diaphragm end face. When pressure acts on a pressure sensitive film, the pressure sensitive film deforms, resulting in a change in the cavity length of the Fabry-Perot, thereby achieving sensing and measurement. The optical fiber Fabry-Perot pressure sensor is simple in structure and easy to implement. It is the most commonly used interferometric optical fiber pressure sensor currently. Pressure sensitive films of some sensors are prepared using a micro-electromechanical system (MEMS) bulk silicon process and a surface sacrificial layer process. Pressure sensitive films of some other sensors are prepared by using an optical fiber corrosion welding process. In recent years, some design schemes have emerged. For example, Jie Zhou, Samhita Dasgupta, et al. from the University of Cincinnati developed an optical fiber Fabry-Perot pressure sensor using a bulk silicon process in 2001 (see optically interrogated MEMS pressure sensors for propulsion applications, Optical Engineering, 2001, 40:598-604.): a monocrystalline silicon film was used as a pressure sensitive film, a shallow cylindrical cavity was etched in glass with an HF buffer solution, the silicon film and the glass were tightly bonded together by an electrostatic bonding process to form a Fabry-Perot cavity, and finally, an optical fiber and a sensor chip were aligned and bonded with epoxy resin. Due to creep of the epoxy resin under the action of an external environment, the coupling angle between the optical fiber and the sensor chip will change, thereby leading to drift in a zero-point output of the sensor.

MEMS optical fiber pressure sensors combine the advantages of miniaturization, high reliability, and high consistency of an MEMS technology and the advantages of an optical fiber signal readout technology, significantly expanding the application range of high-precision pressure sensors. High-precision MEMS optical fiber sensors typically adopt wavelength demodulation methods, especially an F-P optical interference cavity (Fabry-Perot) interference type. A working principle thereof is to integrate a pressure sensitive film with an F-P optical interference cavity. The pressure sensitive film undergoes translational displacement under external pressure, the length of the F-P optical interference cavity synchronously changes, and the interference wavelength thereof also changes. The change in the wavelength is read out through an optical fiber, thereby measuring the external pressure. For specific details, please refer to the Chinese patent application CN201410728291.6 in the prior art, which discloses the measurement of pressure using an F-P optical interference cavity. This sensor has a film-island structure arranged in the F-P optical interference cavity.

Since the dynamic detection resolution of a multi-beam F-P interferometer for the cavity length can reach 1 pm to 10 pm, while the dynamic detection resolution of a dual-beam F-P interferometer for the cavity length can only reach the order of 100 pm to 1 nm, and therefore the sensitivity of the pressure sensor can be greatly improved by constructing the multi-beam F-P interferometer in a pressure sensitive chip. However, during the construction of the multi-beam F-P interferometer, optical films need to be deposited to enhance the optical reflectivity of two reflective surfaces of the F-P interferometer. Moreover, there are extremely high requirements for the parallelism and cleanliness of the two reflective surfaces, only in this way can laser signals incident in the cavity be maintained to undergo hundreds of reflections between the two reflective surfaces, thereby meeting basic conditions of multi-wavelength interference. Due to the temperature limit of 500°C to 600°C of the optical films, the optical films of the reflective surfaces of the multi-beam F-P interferometer inside the MEMS chip can be kept intact only by adopting a silicon-glass bonding process within the temperature range of 300°C to 400°C. However, gas emitted by silicon-glass bonding can cause decrease in the vacuum degree of an interference cavity inside the multi-beam F-P interferometer and introduce unstable refractive indexes, affecting the low-pressure measurement range and zero-point stability of the MEMS pressure sensitive chip. Moreover, it will also increase the temperature coefficient and reduce the measurement repeatability. In order to achieve high-precision pressure measurement, this type of sensor usually requires vacuuming the interior of the F-P optical interference cavity, and the vacuum degree needs to keep stable. Usually, some residual gas will remain in the cavity during the manufacturing process. Therefore, it is necessary to seal a getter in the vacuum chamber and activate the getter during the manufacturing process of the sensor to absorb the residual gas in the F-P optical interference cavity, achieving high vacuum inside the pressure sensor. Chinese patent application CN20121017590.0 discloses an MEMS chip packaging structure. Usually, a getter is deposited inside an F-P optical interference cavity by physical vapor deposition (PVD). To ensure that the residual gas is absorbed completely, the getter usually occupies a relatively large area. Therefore, when the range of the sensor is increased by reducing the area of the pressure sensitive film, the limitation imposed by the getter area becomes a constraining factor. In addition, the getter is of a porous structure, with poor density. When the getter is heated or vibrated externally, particles will be generated, which will contaminate the F-P optical interference cavity and potentially lead to spectral deterioration, greatly affecting the measurement of the optical sensor, especially causing device failure in severe cases. Chinese patent application CN201410264998.6 relates to a hybrid wafer-level vacuum packaging method. Getter cavities are formed in a side of a chip packaging cavity and communicated through vent holes, and covers are fixed after a getter is fixed to the getter cavities. This structure and method also have the potential for the getter to contaminate an F-P optical interference cavity. Moreover, in this method, the getter cavities and getter are superimposed after a chip is formed, such that the manufacturing process is complex. Moreover, there is a certain possibility that getter particles enter a working cavity through vent hole passages. The getter particles have a certain insulating property and have a relatively small impact on electrical detection sensors.

When the getter is manufactured inside or above or below a pressure sensitive structure, decrease in the area of the pressure sensitive structure will be limited in the presence of the getter. During high-pressure measurement of a sensor structure disclosed in the Chinese patent application CN201410728291.6, a relatively small pressure sensitive film is required, which reduces the volume of the F-P optical interference cavity, posing a challenge for the arrangement of a getter film.

In addition, after an MEMS pressure sensitive chip and an optical fiber are coupled and packaged into an MEMS optical pressure module, secondary packaging is usually required for fixing the module to a pressure sensor housing, so as to achieve sealed pressure extraction, module measurement, isolation and protection of an outgoing cable and become an MEMS optical pressure sensor that can be independently mounted and used. During secondary packaging of a structure of a sensitive chip recited in CN201410728291.6, a multi-beam F-P interferometer will be subjected to uneven stress whether external mechanical force on a housing is conducted to the MEMS pressure-sensitive chip or to a welding and packaging position between the MEMS pressure sensitive chip and an optical fiber, resulting in the deterioration of an interference spectrum, measured values will change abnormally, and meanwhile a zero-point output of the sensor will drift.

### SUMMARY

The present application provides a vacuum microcavity interferometer chip in order to overcome the defects of optical fiber pressure sensors in the prior art. The vacuum microcavity interferometer chip includes a first substrate and a second substrate. Preferably, the first substrate is a silicon substrate or a silicon nitride wafer or a substrate with similar functions, the second substrate is a glass substrate or a sapphire substrate or a substrate with similar functions, and the first substrate and the second substrate can be bonded and fixed by selecting silicon-glass bonding or corresponding dielectric layers, such as benzocyclobutene (BCB) glue, gold layer or glass paste. The second substrate and the first substrate are bonded together as a whole, a pressure sensitive film is manufactured on the first substrate, a first reflective surface is deposited on the pressure sensitive film, a second reflective surface corresponding to the first reflective surface is deposited on the second substrate, and after the two substrates are bonded, the first reflective surface and the second reflective surface form an F-P optical interference cavity. At least one getter cavity is formed in the first substrate and/or the second substrate, getter film are arranged on surfaces of the getter cavity, the getter cavity and the F-P optical interference cavity are communicated through gas passages, and the first reflective surface and the second reflective surface are arranged in the F-P optical interference cavity. After the second substrate and the first substrate are bonded together as a whole, the getter cavities form sealed structures, and are communicated with the F-P optical interference cavity only through the gas passages. On the side of the second substrate facing away from the first substrate, an optical fiber collimator is mounted. By means of the above structure, the getter cavities are connected with the F-P optical interference cavity through the gas passages, the getter cavities can be independently arranged, it is ensured that the getter cavities have enough surface area to absorb residual gas in the F-P optical interference cavity, and it is also ensured that the area of the pressure sensitive film is small enough during high-pressure measurement, meeting the requirements of high-sensitivity pressure measurement within a wide range.

In a further preferred embodiment, the pressure sensitive film is of a film-island structure with a center thicker than a periphery in order to reduce bending of a center of the pressure sensitive film under the action of external pressure.

In a further preferred embodiment, the getter cavity is formed in the first substrate. The manufacturing cost can be reduced by arranging the getter cavity in the first substrate due to a mature etching process of the silicon substrate. Furthermore, the number of the getter cavities is two or more, and the plurality of getter cavities are centrally symmetric about the F-P optical interference cavity, such that the vacuum degree of the F-P optical interference cavity can be reduced to the maximum degree, and the vacuum degree of the F-P optical interference cavity is kept in a high-vacuum reference environment at 10⁻⁵ Pa.

Further preferably, the number of the getter cavities is two or four, and the two or four getter cavities are centrally symmetric about the F-P optical interference cavity, thereby achieving consistent temperature coefficients of left and right and/or upper and lower ends of a sensor, preventing different deformations on two sides during thermal expansion and contraction probably caused by asymmetry on two sides, and reducing the difficulty of temperature compensation of the sensor.

In a further preferred embodiment, an optical anti-reflection film is deposited on a side of the second substrate facing away from the first substrate, wherein the second reflective surface and the optical anti-reflection film are deposited on two different surfaces of the second substrate and are concentrically aligned. A third substrate is further arranged, which is a silicon substrate, the third substrate and the second substrate are bonded together as a whole, a mounting hole is formed in the third substrate, the optical fiber collimator is mounted in the mounting hole, and the first reflective surface, the second reflective surface, the optical anti-reflection film, the mounting hole, and the optical fiber collimator have the same axis.

In a further preferred embodiment, the gas passage has a diameter ranging from 10 micrometers to 100 micrometers. In this way, even under extreme conditions where the getter film generates particles due to external heating or vibration, the diameter of the gas passage can restrict the particles from entering the F-P optical interference cavity.

In a preferred embodiment, the size of the second substrate is larger than that of the first substrate and the third substrate. Thus, when the sensor is manufactured using the vacuum microcavity interferometer chip, an exposed surface is formed because the second substrate is larger than the first and third substrates, and this exposed surface is bonded or welded to the sensor housing. The first substrate, the third substrate, and the optical fiber collimator are not in contact with the sensor housing, thereby achieving stress isolation among the film-island structure of the vacuum microcavity interferometer chip, the optical fiber collimator on the third substrate, and the sensor housing. When the sensor housing is subjected to force or vibration, the force or vibration is directly transmitted to the second substrate. The first and third substrates, being arranged on opposite sides of the second substrate in an approximately symmetric manner, vibrate as a whole, so that no stress is applied to the film-island structure or the optical fiber collimator on the third substrate. This reduces variations in the zero-point output of the vacuum microcavity interferometer chip during on-site mechanical fastening or under external force impact.

The present disclosure further relates to a manufacturing method of the vacuum microcavity interferometer chip, specifically comprising the following steps: 1) etching a first substrate to form getter cavities, gas passages, and a pressure sensitive film. One side of the pressure sensitive film is configured to sense pressure, and the other side has a substantially concave cavity structure, such that the thickness of the pressure sensitive film is less than that of the first substrate and can deform under applied pressure. The thickness of the pressure sensitive film determines the amount of deformation under the same pressure, and an appropriate thickness can be selected according to the pressure range to be measured; 2) depositing a first reflective surface on the pressure sensitive film; 3) deposition of layers on a second substrate: a getter film, a second reflective surface, and an optical anti-reflection film are deposited on a second substrate at positions corresponding to the getter cavities, the first reflective surface on the pressure sensitive film, and a mounting holes. By completing the deposition of the getter film, the second reflective surface, and the optical anti-reflection film in the second substrate deposition step, the fabrication process is simplified compared to the conventional hermetic sealing method, in which the getter cavity and the getter are added in a post-chip-formation process. This also reduces the number of stacked substrates. Moreover, by depositing the getter film on the second substrate rather than on the first substrate, the potential for deformation of the pressure sensitive film caused by stress in the getter film is reduced; and 4) bonding the first substrate, the second substrate and the third substrate together as a whole at a temperature greater than 300°C; where the bonding temperature exceeds an activation temperature of the getter films, such that the getter films are activated in the bonding process, thereby eliminating the need to activate the getter after device manufacturing. When external pressure exists, the pressure sensitive film is subject to the external pressure to undergo translational displacement, the length of the F-P optical interference cavity synchronously changes, the interference wavelength thereof also changes, and spectral signals are coupled and transmitted to a full-spectrum analyzer at a rear end through optical fibers to read out the change in the interference wavelength or the change in continuous wavelengths across a plurality of free spectral domains, thereby measuring the external pressure. The pressure sensor in the present disclosure can measure absolute pressure less than barometric pressure due to the high-vacuum state in the cavity. When measuring pressure of 10 MPa or higher, the area of the pressure sensitive film can be reduced to meet the range requirements, without being constrained by the area occupied by the getter.

In a further preferred embodiment, the getter films have poor stability, and will react with a plurality of solutions in a PVD process. In the step of depositing layers on the second substrate, the getter films are finally deposited, that is, the getter films are deposited after the second reflective surface and the optical anti-reflection film are deposited.

The present application further relates to a pressure sensor, including a sensor housing and a chip mounting seat arranged in the sensor housing. The vacuum microcavity interferometer chip is in contact with and fixed to the chip mounting seat only through the second substrate. By means of the structure, stress isolation among the film-island structure of the vacuum microcavity interferometer chip, the optical fiber collimator on the third substrate, and the sensor housing is achieved, when the sensor housing is subject to force or vibration, the force or vibration will be directly transmitted to the second substrate, the first substrate and the third substrate will vibrate overall since they are arranged on two sides of the second substrate and have approximately symmetric structures, and no stress is applied to the film-island structure and the optical fiber collimator on the third substrate, thereby ensuring no change in the zero-point output of the vacuum microcavity interferometer chip before and after fastened mounting of machinery on site or during external force impact.

By means of the MEMS pressure sensor according to the present disclosure, the MEMS structure and the high-precision F-P optical interference cavity are integrated and manufactured, thereby naturally possessing the characteristic of high precision. The getter is added to the sensor structure, which can absorb residual gas in the F-P optical interference cavity, thereby improving the zero-point stability of the sensor to achieve higher detection precision. The getter cavities and the F-P optical interference cavity in the MEMS pressure sensor chip can be formed during the front-end process. Compared to the conventional hermetic sealing method, in which the getter cavity and the getter are added in a post-chip-formation process, the fabrication process is simplified, and the number of stacked substrates is also reduced. The getter cavities and the F-P optical interference cavity are separated and connected through the gas passages, and the gas passage can be made sufficiently small, so as to prevent any small quantity of particles generated after getter activation from contaminating the optical films, leading to device failure. The area of the F-P optical interference cavity (namely the area of the pressure sensitive film) and the area of the getter can be independently adjusted without influences according to use requirements. The whole sensor is of a sealed structure and is not provided with a physical passage or structure externally connected with the chip, so that the overall airtightness of the chip is ensured, and the vacuum degree requirement of subsequent housing packaging is reduced. The chip is of a three-layer bonding structure, and a plurality of structures and materials such as the pressure sensitive film, the F-P interference cavity, and the getter are integrated and miniaturized. The bonding temperature is controlled, the getter films are activated in the bonding process, the manufacturing process of the sensor is simplified, and the getter films are activated without independently consuming energy.

### BRIEF DESCRIPTION OF THE DRAWINGS

FIG. 1 is a schematic diagram of an overall structure of an MEMS pressure sensor according to the present disclosure;
FIG. 2 is a bottom view of a first substrate according to the present disclosure;
FIG. 3 is a top view of a second substrate according to the present disclosure;
FIG. 4 is a schematic diagram of another embodiment according to the present disclosure;
FIG. 5 is a schematic structural diagram of a wide-range optical pressure sensor according to the present disclosure;
FIG. 6 is an enlarged schematic diagram of a partial structure in FIG. 5 according to the present disclosure; and
FIG. 7 is a flowchart of a manufacturing method of an MEMS sensor according to the present disclosure.

Brief description of reference signs:
1-first substrate; 11-pressure sensitive film; 12-first reflective surface; 13-second reflective surface; 14-getter cavity; 15-getter film; 16-gas passage; 2-second substrate; 21-optical anti-reflection film; 3-third substrate; 4-optical fiber collimator; 5-sensor, 51-sensor housing; and 52-chip mounting seat.

### DETAILED DESCRIPTION OF THE EMBODIMENTS

In order to more clearly explain the embodiments of the present disclosure or the technical solutions of the prior art, the drawings needed in the description of the embodiments or the prior art will be briefly described below. Apparently, the drawings in the following description are merely some embodiments of the present disclosure. For those ordinarily skilled in the art, other drawings can be obtained in accordance with these drawings without involving any inventive effort.

For the sake of simplicity of the drawings, the parts relevant to the present disclosure are shown only schematically in the drawings, which do not represent the actual structure thereof as a product. Additionally, in order to simplify the drawings for ease of understanding, components having the same structure or function in some drawings are shown schematically with only one of them, or only one of them is labeled. Herein, "a" means not only "only this one" but also "more than one" case.

It should also be understood that the term "and/or" used in the specification and the appended claims of the present application means any combination of one or more of associated listed items and all possible combinations, and includes these combinations.

Here, it needs to be noted that unless otherwise clearly specified and limited, terms "disposed", "coupled", and "connected" should be broadly understood. For example, the terms may refer to fixed connection, detachable connection or integrated connection; the terms may refer to mechanical connection or electric connection; and the terms may refer to direct connection, indirect connection through an intermediate medium, or communication between interiors of two elements. For a person of ordinary skill in the art, the specific meaning of the above terms in the present disclosure can be understood according to specific circumstances.

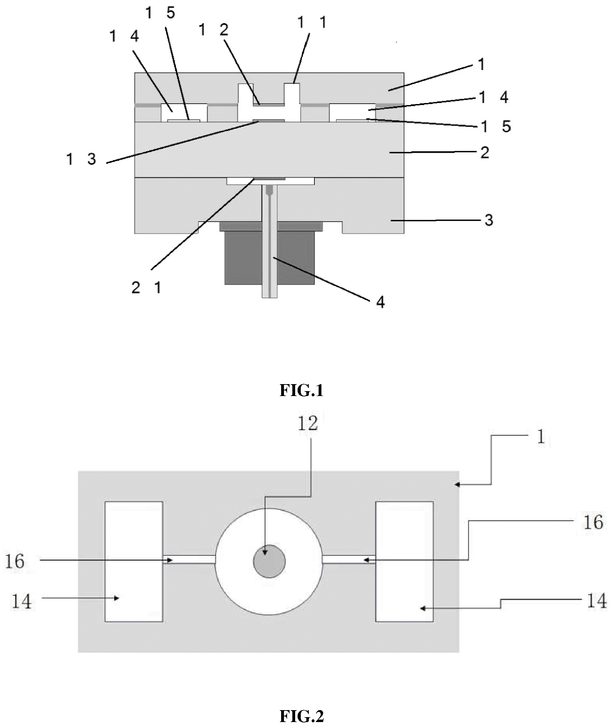

The present application provides a vacuum microcavity interferometer chip in order to overcome the defects of pressure sensors in the prior art. The vacuum microcavity interferometer chip includes a first substrate 1 and a second substrate 2. Preferably, the first substrate is a silicon substrate or a silicon nitride wafer or a substrate with similar functions, the second substrate is a glass substrate or a sapphire substrate or a substrate with similar functions, and the first substrate and the second substrate can be bonded and fixed by selecting silicon-glass bonding or corresponding dielectric layers, such as BCB glue, gold layer or glass paste. The second substrate 2 and the first substrate 1 are bonded together as a whole, a pressure sensitive film 11 is manufactured on the first substrate 1, a first reflective surface 12 is deposited on the pressure sensitive film 11, a second reflective surface 13 corresponding to the first reflective surface 12 is deposited on the second substrate 2, and after the two substrates are bonded, the first reflective surface and the second reflective surface form an F-P optical interference cavity. At least one getter cavity 14 is formed in the first substrate 1 and/or the second substrate 2. FIG. 1 illustrates that the getter cavities and the F-P optical interference cavity are formed in the first substrate. In other embodiments, the getter cavities 14 and the F-P optical interference cavity may be formed in the second substrate, or one part of the getter cavities 14 and the F-P optical interference cavity are formed in the first substrate, and the other part of the getter cavities and the F-P optical interference cavity are formed in the second substrate. Getter films 15 are arranged on surfaces of the getter cavities 14, the getter cavities 14 and the F-P optical interference cavity are communicated through gas passages 16, and the first reflective surface 12 and the second reflective surface 13 are arranged in the F-P optical interference cavity. After the second substrate 2 and the first substrate 1 are bonded together as a whole, the getter cavities 14 form sealed structures that have no opening other than the gas passages 16 and are communicated with the F-P optical interferometer cavity only through the gas passages 16, as shown in FIG. 1. By means of the above structure, the getter cavities 14 are connected with the F-P optical interference cavity through the gas passages 16, the getter cavities 14 can be independently arranged, it is ensured that the getter cavities 14 have enough surface area to absorb residual gas in the F-P optical interference cavity, and it is also ensured that the area of the pressure sensitive film 11 is small enough during high-pressure measurement, meeting the requirements for corresponding measurement sensitivity.

In a further preferred embodiment, the pressure sensitive film 11 is of a film-island structure with a center thicker than a periphery in order to reduce bending of a center of the pressure sensitive film 11 under the action of external pressure.

In a further preferred embodiment, the getter cavities 14 are formed in the first substrate 1. The manufacturing cost can be reduced by arranging the getter cavities 14 in the first substrate 1 due to a mature etching process of the silicon substrate. Furthermore, the number of the getter cavities 14 is two or more, and the plurality of getter cavities 14 are centrally symmetric about the F-P optical interference cavity, such that the vacuum degree of the F-P optical interference cavity can be reduced to the maximum degree, and the vacuum degree of the F-P optical interference cavity is kept in a high-vacuum reference environment at 10⁻⁵ Pa.

Further preferably, the number of the getter cavities 14 is two or four, and the two or four getter cavities 14 are centrally symmetric about the F-P optical interference cavity. FIG. 2 illustrates that two getter cavities 14 are formed in left and right ends of an MEMS sensor, thereby achieving consistent temperature coefficients of left and right and/or upper and lower ends of the sensor, preventing different deformations on two sides during thermal expansion and contraction probably caused by asymmetry on two sides, and reducing the difficulty of temperature compensation of the sensor.

In a further preferred embodiment, an optical anti-reflection film 21 is deposited on a side face, facing away from the first substrate 1, of the second substrate 2, and the second reflective surface 13 and the optical anti-reflection film 21 are deposited on two different surfaces of the second substrate 2 and are concentrically aligned. A third substrate 3 is further arranged, which is a silicon substrate, the third substrate 3 and the second substrate 2 are bonded together as a whole, a mounting hole is formed in the third substrate 3, an optical fiber collimator 4 is mounted in the mounting hole, and the first reflective surface 12, the second reflective surface 13, the optical anti-reflection film 21, the mounting hole, and the optical fiber collimator 4 have the same axis.

In a further preferred embodiment, the gas passage 16 has a diameter ranging from 10 micrometers to 100 micrometers, such that even in extreme cases where the getter films 15 are heated or vibrated externally to generate particles, the diameter of the gas passage 16 can limit the particles from flowing into the F-P optical interference cavity.

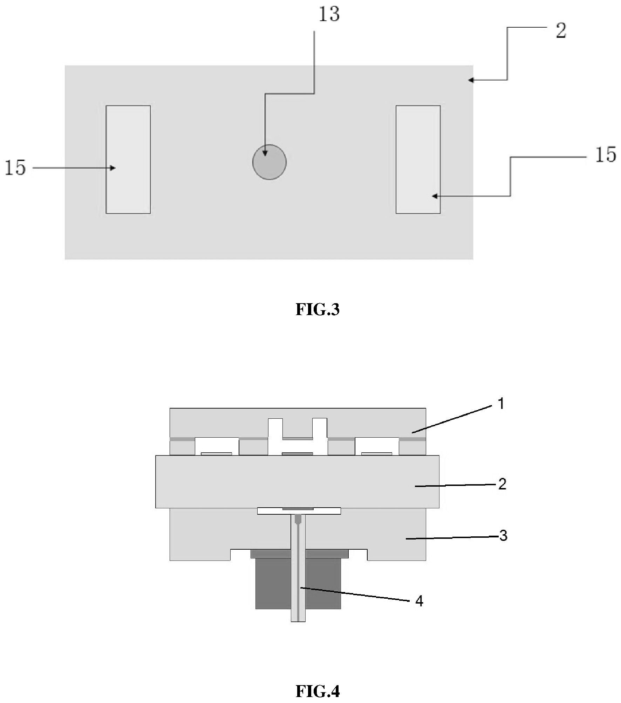

In a preferred embodiment, the second substrate 2 is larger than the first substrate 1 and the third substrate 3, as shown in FIG. 4; the size may be parameters such as length or diameter, which depends on the shape of the second substrate, as long as it can be ensured that the second substrate is partially exposed out of the first substrate or the third substrate; such that when the sensor is manufactured by using the vacuum microcavity interferometer chip, an exposed surface is formed based on that the second substrate is larger than the first substrate and the third substrate in boundary dimension, and bonded or welded and fixed to a sensor housing, and the first substrate, the third substrate, and the optical fiber collimator are not in contact with the sensor housing. Stress isolation among the film-island structure of the vacuum microcavity interferometer chip, the optical fiber collimator on the third substrate, and the sensor housing is achieved, when the sensor housing is subject to force or vibration, the force or vibration will be directly transmitted to the second substrate, the first substrate and the third substrate will vibrate overall since they are arranged on two sides of the second substrate and have approximately symmetric structures, and no stress is applied to the film-island structure and the optical fiber collimator on the third substrate, thereby ensuring no change in a zero-point output of the vacuum microcavity interferometer chip before and after fastened mounting of machinery on site or during external force impact.

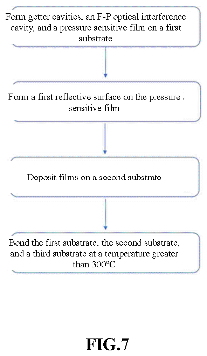

The present disclosure further relates to a manufacturing method of the sensor for measuring pressure, as shown in FIG. 7, specifically including the steps: 1) a first substrate 1 is etched to form getter cavities 14, gas passages 16, and a pressure sensitive film 11; where one side of the pressure sensitive film 11 is used to sense pressure, and an approximately cavity structure is arranged on the other side of the pressure sensitive film, such that the thickness of the pressure sensitive film 11 is less than that of the first substrate, the pressure sensitive film can undergo translational displacement under the action of pressure, the thickness of the pressure sensitive film 11 determines the displacement under the same pressure, and an appropriate thickness can be selected according to a measured pressure range; 2) a first reflective surface 12 is deposited on the pressure sensitive film 11; 3) films are deposited on a second substrate: getter films 15, a second reflective surface 13, and an optical anti-reflection film 21 are deposited at positions, corresponding to the getter cavities 14, the pressure sensitive film 11, and a mounting hole, of the second substrate 2, as shown in FIG. 3; where the getter films, the second reflective surface 13, and the optical anti-reflection film 21 are deposited in the step of deposition layers on the second substrate, such that the manufacturing process is simpler and laminated substrates are fewer compared with a traditional hermetic packaging method where getter cavities 14 and a getter are superposed after chip forming, namely in a later process; meanwhile, the getter films 15 are deposited on the second substrate 2, such that the potential possibility of deformation of the pressure sensitive film 11 is reduced compared with a method for arranging the getter films on the first substrate 1; and 4) the first substrate 1, the second substrate 2, and the third substrate 3 are bonded together as a whole at a temperature greater than 300°C; where the bonding temperature exceeds an activation temperature of the getter films 15, such that the getter films 15 are activated in the bonding process, thereby eliminating the need to activate the getter after device manufacturing. When external pressure exists, the pressure sensitive film 11 is subject to the external pressure to undergo translational displacement, the length of the F-P optical interference cavity synchronously changes, the interference wavelength thereof also changes, and spectral signals are coupled and transmitted to a full-spectrum analyzer at a rear end through optical fibers to read out the change in the interference wavelength or the change in continuous wavelengths across a plurality of free spectral domains, thereby measuring the external pressure. The pressure sensor in the present disclosure can measure absolute pressure less than barometric pressure due to the high-vacuum state in the cavity. When measuring pressure of 10 MPa or higher, the area of the pressure sensitive film can be reduced to meet the range requirements, without being constrained by the area occupied by the getter.

In a further preferred embodiment, the getter films have poor stability, and will react with a plurality of solutions in a PVD process. In the step of deposition layers on the second substrate, the getter films are finally deposited, that is, the getter films are deposited after the second reflective surface 13 and the optical anti-reflection film 21 are deposited.

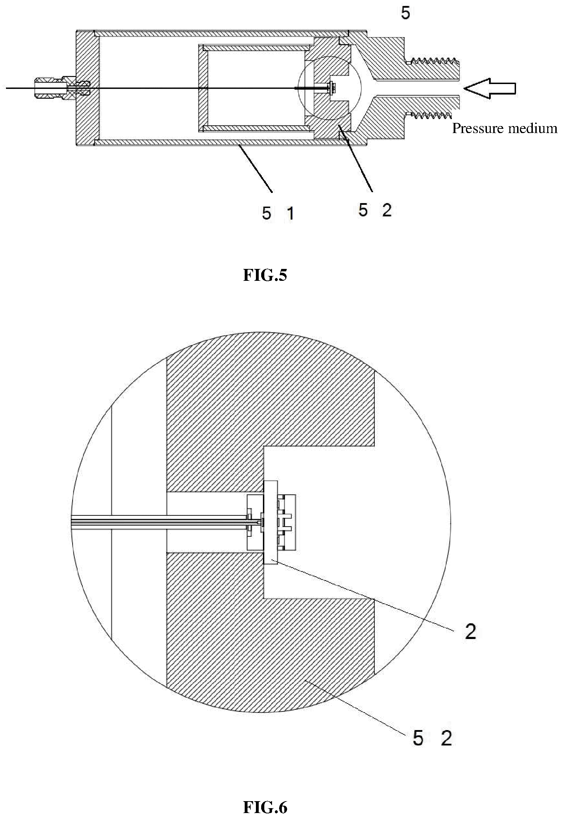

The present application further relates to a wide-range optical pressure sensor, including a sensor housing 51 and a chip mounting seat 52 arranged in the sensor housing 51, as shown in FIG. 5 and FIG. 6. The vacuum microcavity interferometer chip is in contact with and fixed to the sensitive chip mounting seat only through the second substrate. By means of the structure, stress isolation among the film-island structure of the vacuum microcavity interferometer chip, the optical fiber collimator on the third substrate, and the sensor housing is achieved, when the sensor housing is subject to force or vibration, the force or vibration will be directly transmitted to the second substrate, the first substrate and the third substrate will vibrate overall since they are arranged on two sides of the second substrate and have approximately symmetric structures, and no stress is applied to the film-island structure and the optical fiber collimator on the third substrate, thereby ensuring no change in the zero-point output of the vacuum microcavity interferometer chip before and after fastened mounting of machinery on site or during external force impact.

## Claims

1. A vacuum microcavity interferometer chip, comprising a first substrate and a second substrate; **characterized in that** a pressure sensitive film is manufactured on the first substrate, a first reflective surface is deposited on the pressure sensitive film, a second reflective surface corresponding to the first reflective surface is deposited on the second substrate, and after the two substrates are bonded, the first reflective surface and the second reflective surface form an F-P optical interference cavity; at least one getter cavity is formed in the first substrate and/or the second substrate, getter films are arranged on surfaces of the getter cavities, the getter cavities and the F-P optical interference cavity are communicated through gas passages, and the first reflective surface and the second reflective surface are arranged in the F-P optical interference cavity; and after the second substrate and the first substrate are bonded together as a whole, the getter cavities form sealed structures, and are communicated with the F-P optical interference cavity only through the gas passages; and an optical fiber collimator is mounted on a side, facing away from the first substrate, of the second substrate.

2. The vacuum microcavity interferometer chip according to claim 1, **characterized in that** the pressure sensitive film is of a film-island structure with a center thicker than a periphery.

3. The vacuum microcavity interferometer chip according to any one of claims 1-2, **characterized in that** the getter cavities are formed in the first substrate.

4. The vacuum microcavity interferometer chip according to claim 3, **characterized in that** the number of the getter cavities is two or four, and the two or four getter cavities are centrally symmetric about the F-P optical interference cavity.

5. The vacuum microcavity interferometer chip according to claim 3, **characterized in that** an optical anti-reflection film is deposited on a side face, facing away from the first substrate, of the second substrate, and the second reflective surface and the optical anti-reflection film are deposited on two different surfaces of the second substrate and are concentrically aligned.

6. The vacuum microcavity interferometer chip according to claim 5, **characterized in that** a third substrate is further arranged, a mounting hole is formed in the third substrate, the optical fiber collimator is mounted in the mounting hole, and the first reflective surface, the second reflective surface, the optical anti-reflection film, the mounting hole, and the optical fiber collimator have the same axis.

7. The vacuum microcavity interferometer chip according to claim 3, **characterized in that** the gas passage has a diameter ranging from 10 micrometers to 100 micrometers.

8. The vacuum microcavity interferometer chip according to claim 3, **characterized in that** the getter films are deposited on the second substrate.

9. The vacuum microcavity interferometer chip according to any one of claims 1-2, **characterized in that** the second substrate is larger than the first substrate and the third substrate.

10. A manufacturing method of the vacuum microcavity interferometer chip according to any one of claims 1-9, specifically comprising the steps: 1) etching a first substrate to form getter cavities, gas passages, and a pressure sensitive film; 2) depositing a first reflective surface on the pressure sensitive film; 3) deposition of layers on a second substrate: a getter film, a second reflective surface, and an optical anti-reflection film are deposited on a second substrate at positions corresponding to the getter cavities, the first reflective surface, and a mounting hole, of the second substrate; and 4) bonding the first substrate, the second substrate, and the third substrate together as a whole at a temperature greater than 300°C.

11. The manufacturing method of the vacuum microcavity interferometer chip according to claim 10, **characterized in that** in the step of deposition layers on the second substrate, the getter films are deposited finally.

12. A wide-range optical pressure sensor, comprising a sensor housing and a chip mounting seat arranged in the sensor housing, wherein the vacuum microcavity interferometer chip according to any one of claims 1-9 is in contact with and fixed to the chip mounting seat only through the second substrate.
